# EUROPÄISCHE PATENTANMELDUNG

(11) **EP 0 862 204 A1**
(43) Veröffentlichungstag der Anmeldung: **02.09.1998**
(21) Anmeldenummer: 98101832.8
(22) Anmeldetag: 03.02.1998
(51) Int. Cl.: H01L 21/3205, H01L 27/108, H01L 29/92

(54) **Verfahren zur Herstellung eines Kondensators für eine Halbleiteranordnung**

(30) Priorität: 27.02.1997 DE 19707977
(71) Anmelder: SIEMENS AKTIENGESELLSCHAFT, 80333 München (DE)
(72) Erfinder: Franosch, Martin, 81739 München (DE); Lange, Gerrit, Dr., 81373 München (DE); Lehmann, Volker, Dr., 80689 München (DE); Reisinger, Hans, Dr., 82031 Grünwald (DE); Schäfer, Herbert, Dr., 85635 Höhenkirchen-Siegertsbrunn (DE); Stengl, Reinhard, Dr., 86391 Stadtbergen (DE); Wendt, Hermann, Dr., 85630 Grasbrunn (DE)

(57) **Zusammenfassung**

Zur Herstellung eines Kondensators, insbesondere für eine dyamische Speicherzellenanordnung mit Stapelkondensatoren, wird eine Schichtenfolge erzeugt, die alternierend Schichten aus dotiertem Silizium und germaniumhaltige Schichten enthält. Aus der Schichtenfolge werden Schichtstrukturen gebildet, deren Flanken jeweils mit einer leitfähigen Stützstruktur (5) versehen werden. In den Schichtstrukturen werden Öffnungen, insbesondere Spalten gebildet, in denen die Oberfläche der Schichten freiliegt. Die germaniumhaltigen Schichten werden selektiv zu den Schichten aus dotiertem Silizium entfernt. Die freiliegende Oberfläche der Schichten aus dotiertem Silizium (4₁) und der Stützstruktur (5) werden mit einem Kondensatordielektrikum (6) versehen, auf das eine Gegenelektrode (7) aufgebracht wird.

## Beschreibung

Für verschiedene integrierte Schaltungstypen, wie zum Beispiel dynamische Speicherzellenanordnungen, Analog Digital- und Digital Ahalog-Wandler sowie Filterschaltungen, werden Kondensatoren auf Halbleiterbasis benötigt. Bei der Herstellung von Kondensatoren auf Halbleiterbasis ist im Hinblick auf eine erhöhte Integrationsdichte oder reduzierte Chipfläche das Problem zu lösen, den Platzbedarf des Kondensators bei gleichbleibender Kapazität zu reduzieren.

Dieses Problem ist besonders gravierend bei dynamischen Halbleiterspeichern, bei denen die benötigte Fläche der im allgemeinen verwendeten Eintransistorspeicherzelle von Speichergeneration zu Speichergeneration mit zunehmender Speicherdichte reduziert wird. Gleichzeitig muß eine gewisse Mindestkapazität des Speicherkondensators erhalten bleiben.

Eine Eintransistorspeicherzelle einer dynamischen Halbleiterspeicheranordnung (DRAM-Speicheranordnung) umfaßt einen Auslesetransistor und einen Kondensator. In dem Kondensator ist die Information in Form einer elektrischen Ladung gespeichert, die eine logische Größe, Null oder Eins, darstellt. Durch Ansteuerung des Auslesetransistors über eine Wortleitung kann diese Information über eine Bitleitung ausgelesen werden. Zur sicheren Speicherung der Ladung und gleichzeitigen Unterscheidbarkeit der ausgelesenen Information muß der Kondensator eine Mindestkapazität aufweisen. Die untere Grenze für die Kapazität des Speicherkondensators wird derzeit bei 25 fF gesehen.

Bis zur 1MBit-Generation wurden sowohl der Auslesetransistor als auch der Kondensator als planare Bauelemente realisiert. Ab der 4MBit-Speichergeneration wurde eine weitere Flächenreduzierung der Speicherzelle durch eine dreidimensionale Anordnung von Auslesetransistor und Speicherkondensator erzielt. Eine Möglichkeit dafür besteht darin, den Speicherkondensator in einem Graben zu realisieren (siehe zum Beispiel K. Yamada et al, Proc. Intern. Electronic Devices and Materials IEDM 85, Seite 702 ff). Die Elektroden des Speicherkondensators sind in diesem Fall entlang der Oberfläche des Grabens angeordnet. Dadurch wird die effektive Fläche des Speicherkondensators, von der die Kapazität abhängt, gegenüber dem Platzbedarf an der Oberfläche des Substrats für den Speicherkondensator, der dem Querschnitt des Grabens entspricht, vergrößert.

Eine weitere Möglichkeit, zur Vergrößerung der Speicherkapazität bei gleichbleibendem oder verringertem Platzbedarf des Speicherkondensators besteht darin, den Speicherkondensator als Stapelkondensator, den sogenannten stacked capacitor, auszuführen. Dabei wird über den Wortleitungen eine Struktur aus Polysilizium, zum Beispiel eine Kronenstruktur oder ein Zylinder, gebildet, die mit dem Substrat kontaktiert wird. Diese Polysiliziumstruktur bildet den Speicherknoten. Er wird mit Kondensatordielektrikum und Kondensatorplatte versehen. Dieses Konzept hat den Vorzug, daß es weitgehend mit einem Logikprozeß kompatibel ist. Für den Speicherkondensator wird der freie Raum oberhalb der Substratoberfläche genutzt. Dabei kann die gesamte Zellfläche von der Polysiliziumstruktur überdeckt sein, solange die Polysiliziumstrukturen zu benachbarten Speicherzellen gegeneinander isoliert sind.

Aus EP 0 415 530 B1 ist eine Speicherzellenanordnung mit einem Stapelkondensator als Speicherkondensator bekannt. Der Stapelkondensator umfaßt eine Polysiliziumstruktur mit mehreren, im wesentlichen parallel übereinander angeordneten Polysiliziumschichten, die über mindestens eine seitliche Stütze miteinander verbunden sind. Diese kühlrippenartig angeordneten Schichten führen zu einer deutlichen Vergrößerung der Oberfläche der Polysiliziumstruktur gegenüber der Projektion der Polysiliziumstruktur auf die Substratoberfläche. Die Polysiliziumstruktur wird durch alternierende Abscheidung von Polysiliziumschichten und selektiv dazu ätzbaren SiO₂- bzw. Kohlenstoffschichten auf der Oberfläche des Substrats, Strukturierung dieser Schichten, Erzeugung von Flankenbedeckungen (Spacer aus Polysilizium) an mindestens einer Flanke der Schichtstruktur und selektives Herausätzen der SiO₂- bzw. Kohlenstoffschichten gebildet. Die Polysiliziumstrukturen sind dabei arsendotiert. Anschließend wird durch thermische Oxidation Siliziumoxid als Kondensatordielektrikum gebildet, auf dem eine Zellplatte aus dotiertem Polysilizium abgeschieden wird.

Aus GB 2 285 338 A ist ein Verfahren zur Herstellung eines Kondensators bekannt, bei dem auf ein Substrat abwechselnd Schichten aus dotiertem und undotiertem Silizium aufgebracht werden. Durch die Schichten hindurch wird ein Kontaktloch geöffnet, das bis in ein darunterliegendes Substrat reicht. Die gesamte Oberfläche wird mit einer undotierten Siliziumschicht bedeckt. Nach Strukturierung der Schichtenfolge liegen die Flanken der Schichten aus dotiertem bzw. undotiertem Silizium frei. Die dotierten Siliziumschichten werden selektiv zu den undotierten Siliziumschichten entfernt. Die dabei entstehende Siliziumstruktur wird durch Diffusion dotiert und als Elektrode des Kondensators verwendet.

Der Erfindung liegt das Problem zugrunde, ein Verfahren zur Herstellung eines Kondensators für eine Halbleiteranordnung, insbesondere für eine DRAM-Anordnung anzugeben, bei dem gegenüber den bekannten Lösungen der Prozeßaufwand reduziert wird. Insbesondere soll der Kondensator mindestens in der für die 1 GBit-Generation erforderlichen Packungsdichte herstellbar sein.

Dieses Problem wird erfindungsgemäß gelöst durch ein Verfahren gemäß Anspruch 1. Weitere Ausgestaltungen der Erfindung gehen aus den übrigen Ansprüchen hervor.

In dem erfindungsgemäßen Verfahren wird auf einem Substrat eine Schichtenfolge erzeugt, die jeweils alternierend eine Schicht aus dotiertem Silizium und eine germaniumhaltige Schicht aufweist. Die Schichtfolge wird so strukturiert, daß mindestens eine Schichtstruktur mit bis auf das Substrat reichenden Flanken entsteht. Es wird eine Stützstruktur aus leitfähigem Material gebildet, die mindestens die Flanken der Schichtstruktur bedeckt. Die Stützstruktur wird durch selektive Epitaxie von Silizium gebildet. Vorzugsweise wird die Stützstruktur in situ dotiert. In der Schichtstruktur wird anschließend mindestens eine Öffnung gebildet, in der die Oberfläche der Schichten aus dotiertem Silizium und der germaniumhaltigen Schichten freiliegt. Anschließend werden die germaniumhaltigen Schichten selektiv zu den Schichten aus dotiertem Silizium und der Stützstruktur entfernt. Die freiliegende Oberfläche der Schichten aus dotiertem Silizium und der Stützstruktur wird mit einem Kondensatordielektrikum versehen. An der Oberfläche des Kondensatordielektrikums wird eine Gegenelektrode gebildet.

Die Stützstruktur ist beim Herausätzen der germaniumhaltigen Schichten vorzugsweise an mindestens drei Flanken der Schichtstruktur angeordnet. Dadurch wird eine hohe mechanische Stabilität gewährleistet, durch die ein Zusammenkleben der Schichten aus dotiertem Silizium beim Herausätzen der germaniumhaltigen Schichten aus dem zweiten Material vermieden wird. Da diese mechanische Stabilität durch die Stützstruktur gewährleistet ist, kann die Schichtdicke der Schichten aus dotiertem Silizium unabhängig von mechanischen Stabilitätsanforderungen an die Schichten aus dotiertem Silizium gewählt werden. Die Schichten aus dotiertem Silizium können insbesondere im Dickenbereich zwischen 20 und 50 nm realisiert werden. Dadurch wird auch die Gesamthöhe des Kondensators bei gleichbleibender Kapazität reduziert.

Die Schichten aus dotiertem Silizium können sowohl polykristallin als auch kristallin oder amorph sein.

Es liegt im Rahmen der Erfindung, die germaniumhaltigen Schichten aus reinem Germanium oder aus Silizium und Germanium zu bilden. Werden die Schichten aus Silizium und Germanium gebildet, so liegt der Germaniumanteil vorzugsweise zwischen 10 Prozent und 100 Prozent. Der Siliziumanteil liegt zwischen 0 Prozent und 90 Prozent. Die germaniumhaltigen Schichten können sowohl dotiert als auch undotiert abgeschieden werden.

Germaniumhaltige Schichten aus reinem Germanium oder aus Silizium und Germanium lassen sich naßchemisch mit guter Selektivität zu Silizium ätzen. Bei Verwendung einer Ätzmischung, die HF, H₂O₂ und CH₃COOH enthält, beträgt die Selektivität der Ätzung zu Silizium 1:30 bis 1:1000. Bei dieser Ätzung beträgt die Selektivität zu Siliziumoxid und Siliziumnitrid etwa 1:30 bis 1:1000.

Mit Cholin lassen sich Siliziumschichten selektiv zu Germanium ätzen.

Da die Diffusionskoeffizienten von Germanium in Silizium und von Silizium in Germanium äußerst gering sind, bleibt die Schichtenfolge auch bei prozeßbedingten Temperaturbelastungen von zum Beispiel 800°C unverändert erhalten. Die Diffusionskoeffizienten liegen bei einer Prozeßtemperatur von 1000°C etwa bei 1,5 x 10⁻⁶ cm²/sec. Zum Vergleich: diese Diffusionskoeffizienten sind damit etwa um einen Faktor 10 geringer als der Diffusionskoeffizient von Bor in Silizium.

Vorzugsweise werden die Schichten aus dotiertem Silizium in einem CVD-Prozeß unter Verwendung von Silan als Prozeßgas im Temperaturbereich zwischen 400 und 600°C bei einem Druck zwischen 10 und 400 Torr und einem Silanfluß von 30 bis 300 sccm mit Abscheideraten von 10 bis 100 nm pro Minute gebildet. Die germaniumhaltigen Schichten werden vorzugsweise durch CVD-Abscheidung unter Verwendung von German bzw. German und Disilan im Prozeßgas bei einer Temperatur zwischen 400 und 600°C und einem Druck zwischen 10 und 400 Torr gebildet, wobei der Germanfluß und gegebenenfalls der Disilanfluß zwischen 30 und 300 sccm eingestellt wird und die Abscheiderate zwischen 10 und 100 nm pro Minute liegt.

Die dotierten Siliziumschichten werden vorzugsweise in situ dotiert abgeschieden. Dazu wird der Abscheidung ein Dotiergas, zum Beispiel Arsin, Phosphin oder Diboran. Die Schichten aus dotiertem Silizium und die Stützstruktur können sowohl aus n-dotiertem als auch aus p-dotiertem Silizium gebildet werden.

Dotiertes Silizium und Germanium können in demselben Reaktor abgeschieden werden. Dadurch kann die Schichtenfolge ohne Anlagenwechsel nur durch Umschalten der Prozeßparameter realisiert werden. Dieses bedeutet eine deutliche Prozeßvereinfachung.

In Anwendungen, in denen die Stützstruktur und die Schichten aus dotiertem Silizium mit dem Substrat elektrisch verbunden werden sollen, ist es vorteilhaft, die Dotierung der Stützstruktur und der Schichten aus dotiertem Silizium entsprechend der Dotierung des Substrates im Bereich der Stützstruktur zu wählen, um die Bildung eines pn-Übergangs zu vermeiden.

Die Stützstruktur wird mit definierten Oberflächen an den Flanken der Schichtstruktur gebildet. Dadurch wird sichergestellt, daß die germaniumhaltigen Schichten gleichmäßig zwischen den Schichten aus dotiertem Silizium herausgeätzt werden. Auf diese Weise wird verhindert, daß die germaniumhaltigen Schichten lokal noch nicht herausgeätzt sind und gleichzeitig an anderen Stellen die Stützflächen schon so stark angegriffen werden, daß einzelne Schichten aus dotiertem Silizium herunterfallen.

Vorzugsweise werden bei der Bildung der Öffnung in der Schichtstruktur die Schichtstruktur und die Stützstruktur in zwei Teilbereiche geteilt, die durch einen bis auf die Oberfläche des Substrats reichenden Spalt beabstandet sind. Aus den beiden Teilbereichen werden zwei Kondensatoren gebildet. Der Abstand und die Strukturgröße der Teilbereiche können dabei jeweils entsprechend der minimalen Strukturgröße F in der jeweiligen Technologie gebildet werden. Dadurch wird eine hohe Packungsdichte erzielt.

Bei Herstellung des Kondensators als Speicherkondensator für eine dynamische Speicherzellenanordnung erfolgt die Herstellung des Kondensators vorzugsweise als Stapelkondensator. In diesem Fall umfaßt das Substrat ein Halbleitersubstrat mit Auswahltransistoren, Bitleitungen, Wortleitungen und einer isolierenden Schicht, auf deren Oberfläche die Schichtenfolge aufgebracht wird. Vorzugsweise wird die isolierende Schicht planarisiert, so daß die Schichtenfolge auf einer im wesentlichen planaren Oberfläche gebildet wird.

Im folgenden wird die Erfindung anhand der Figuren und der Ausführungsbeispiele näher erläutert.
- Figur 1: zeigt ein Substrat mit einer Schichtenfolge, die alternierend Schichten aus dotiertem Silizium und germaniumhaltige Schichten aufweist.
- Figur 2: zeigt das Substrat mit Schichtstrukturen.
- Figur 3: zeigt das Substrat nach Bildung einer Stützstruktur, die die Flanken der Schichtstruktur bedeckt.
- Figur 4: zeigt das Substrat nach Bildung einer Öffnung in den Schichtstrukturen und selektivem Herausätzen von germaniumhaltigen Schichten.
- Figur 5: zeigt das Substrat nach Bildung eines Kondensatordielektrikums und einer Gegenelektrode.
- Figur 6: zeigt den in Figur 5 mit VI-VI bezeichneten Schnitt durch das Substrat.
- Figur 7: zeigt ein Layout, bei dem die Schichtstrukturen versetzt angeordnet sind.
- Figur 8: zeigt ein Layout, bei dem die Schichtstrukturen rasterförmig angeordnet sind.

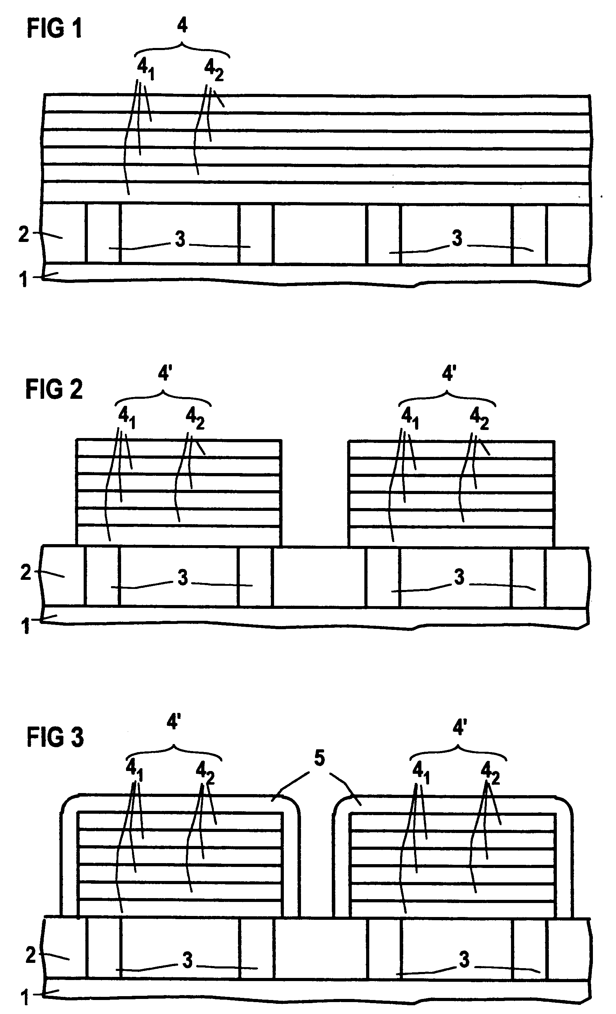

Auf ein Substrat 1 wird eine isolierende Schicht 2 aufgebracht. Das Substrat 1 ist zum Beispiel ein Halbleitersubstrat, insbesondere eine monokristalline Siliziumscheibe, das Auswahltransistoren mit Wortleitungen und Bitleitungen umfaßt. Die isolierende Schicht wird zum Beispiel aus SiO₂ gebildet und mit Hilfe von Planarisierungsverfahren planarisiert (siehe Figur 1). In der isolierenden Schicht 2 werden Kontaktlöcher 3 geöffnet und mit elektrisch leitfähigem Material, zum Beispiel dotiertes Polysilizium, Wolfram, Tantal, Titan, Titannitrid oder Wolframsilizid aufgefüllt. Die Kontaktlöcher 3 werden so angeordnet, daß sie jeweils auf ein Source/Drain-Gebiet eines der Auswahltransistoren im Substrat 1 reichen.

Auf die Oberfläche der isolierenden Schicht 2 wird eine Schichtenfolge 4 aufgebracht, die jeweils alternierend Schichten aus dotiertem Silizium 4₁ und germaniumhaltige Schichten 4₂ umfaßt. Die Schichten aus dotiertem Silizium 4₁ können sowohl p⁺- als auch n⁺-dotiert sein und weisen eine Dotierstoffkonzentration von zum Beispiel 5 x 10²⁰ cm⁻³ auf. Die Schichten aus dotiertem Silizium 4₁ und die germaniumhaltigen Schichten 4₂ werden in einer Schichtdicke von jeweils 20 nm zum Beispiel durch CVD-Abscheidung unter Verwendung von Silan bzw. German oder German und Disilan bei einer Temperatur zwischen 400°C und 600°C und einem Druck zwischen 10 und 400 Torr abgeschieden. Der Gasfluß liegt dabei jeweils zwischen 30 und 300 sccm, die Abscheiderate liegt zwischen 10 und 100 nm/min. Die oberste Schicht der Schichtenfolge ist eine germaniumhaltige Schicht 4₂.

Anschließend werden aus der Schichtenfolge 4 durch anisotropes Ätzen unter Verwendung einer Maske Schichtstrukturen 4' gebildet. Zwischen den Schichtstrukturen 4' liegt die Oberfläche der isolierenden Schicht 2 frei (siehe Figur 2). Das anisotrope Ätzen erfolgt zum Beispiel mit CF₄ und SF₆.

Anschließend wird mittels selektiver Epitaxie von Silizium eine Stützstruktur 5 gebildet (siehe Figur 3). Die selektive Epitaxie wird in einem Prozeß unter Verwendung von SiCl₂H₂, Hcl, H₂ und einem Dotiergas, zum Beispiel B₂H₆ oder PH₃ als Prozeßgas im Temperaturbereich zwischen 700°C und 900°C durchgeführt. Bei der selektiven Epitaxie wächst die Stützstruktur 5 in situ dotiert auf der Oberfläche der Schichtstrukturen 4' auf. Auf der Oberfläche der isolierenden Schicht 2 wächst dagegen kein Silizium auf. Die Stützstruktur 5 bedeckt die Flanken und die Oberfläche der Schichtstrukturen 4' vollständig.

Anschließend werden die Schichtstrukturen 4' mit der sie bedeckenden Stützstruktur 5 unter Verwendung einer photolithographisch erzeugten Maske durch anisotropes Ätzen zum Beispiel mit CF₄ und SF₆ so strukturiert, daß jeweils zwei Teilbereiche entstehen. Die beiden Teilbereiche sind jeweils durch einen Spalt voneinander getrennt. Im Bereich des Spaltes weisen die Teilbereiche jeweils eine Flanke auf, an der die Oberfläche der germaniumhaltigen Schichten 4₂ und der Schichten aus dotiertem Silizium 4₁ freiliegt.

Durch eine zu dotiertem Polysilizium und SiO₂ selektive Ätzung werden anschließend die verbleibenden Teile der germaniumhaltigen Schichten 4₂ entfernt. Die selektive Ätzung erfolgt zum Beispiel naßchemisch mit einer Ätzmischung, die HF, H₂O₂ und CH₃COOH enthält. Vorzugsweise liegt die Konzentration der Lösung in folgendem Bereich: 1 Teil HF, 200 Teile H₂O₂, 300 Teile CH₃COOH. Diese Ätzung weist in Bezug auf dotiertes Polysilizium eine Selektivität von 1:30 bis 1:1000 auf. In Bezug auf Siliziumoxid und Siliziumnitrid weist sie eine Selektivität von 1:30 bis 1:1000 auf.

Die Schichten aus dotiertem Silizium 4₁ und die Stützstruktur 5, die von der selektiven Ätzung nicht angegriffen werden, sind mechanisch und elektrisch miteinander verbunden.

Die Oberfläche der Schichten aus dotiertem Silizium 4₁ und der Stützstruktur 5 wird mit einem Kondensatordielektrikum 6 versehen. Das Kondensatordielektrikum 6 wird zum Beispiel aus einer Dreifachschicht aus SiO₂, Si₃N₄ und SiO₂ in einer oxidäquivalenten Dicke von 4 nm gebildet.

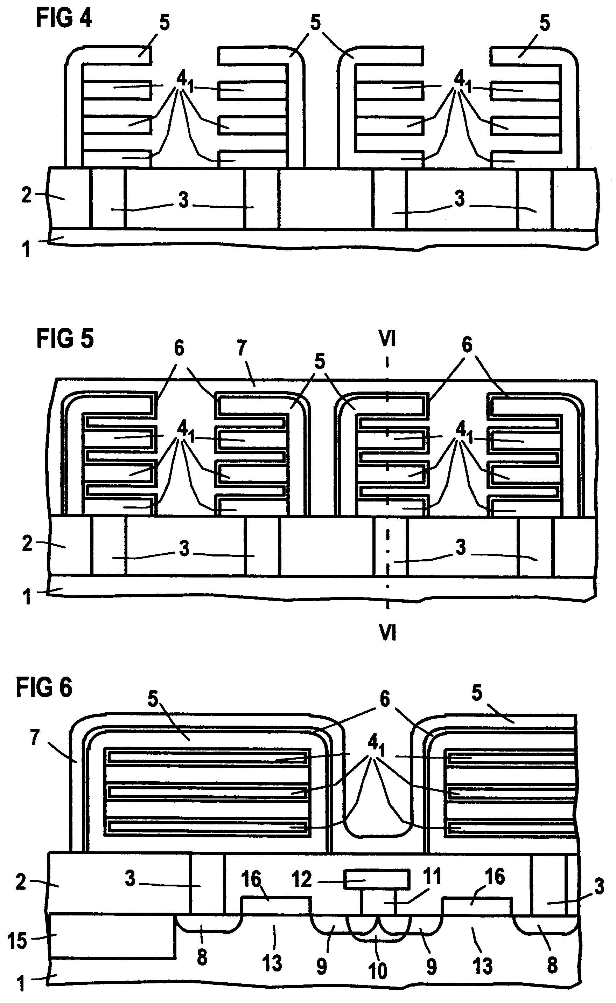

Durch Abscheidung einer in situ dotierten Polysiliziumschicht wird anschließend eine Gegenelektrode 7 gebildet (siehe Figur 5 und Figur 6). Die Gegenelektrode 7 ist zum Beispiel n⁺-dotiert mit einer Dotierstoffkonzentrtion im Bereich von 5 x 10²⁰ cm⁻³.

In dem in Figur 6 dargestellten Schnitt sind im Substrat 1 Auswahltransistoren angedeutet. Die Schichten aus dotiertem Silizium 4₁ und die damit verbundene Stützstruktur 5 bilden jeweils einen Speicherknoten für einen Speicherkondensator. Dieser Speicherknoten ist über den darunter angeordneten Kontakt 3 mit einem Source/Drain-Gebiet 8 eines Auswahltransistors verbunden. Das andere Source/Drain-Gebiet 9 des Auswahltransistors ist über ein Anschlußgebiet 10 mit dem entsprechenden Source/Drain-Gebiet 9 des benachbarten Auswahltransistors verbunden. Das Anschlußgebiet 10 ist ferner über einen vergrabenen Bitleitungskontakt 11 mit einer vergrabenen Bitleitung 12 verbunden. Die vergrabene Bitleitung 12 und der Bitleitungskontakt 11 sind durch die isolierende Schicht 2 umgeben. Zwischen den Source/Drain-Gebieten 8 und 9 eines Auswahltransistors sind das Kanalgebiet 13, ein Gatedielektrikum (nicht dargestellt) und eine als Wortleitung 14 wirkende Gateelektrode angeordnet. Die Wortleitung 14 und der Bitleitungskontakt 11 sind jeweils aus dotiertem Polysilizium gebildet. Die Bitleitung 12 wird aus dotiertem Polysilizium, Wolframsilizid oder Wolfram gebildet. Auf der der Bitleitung 12 abgewandten Seite des Source/Drain-Gebietes 8 ist jeweils eine Isolationsstruktur, zum Beispiel ein flacher, mit isolierendem Material gefüllter Graben 15 (Shallow trench isolation) zur Isolation zwischen benachbarten Auswahltransistorpaaren vorgesehen.

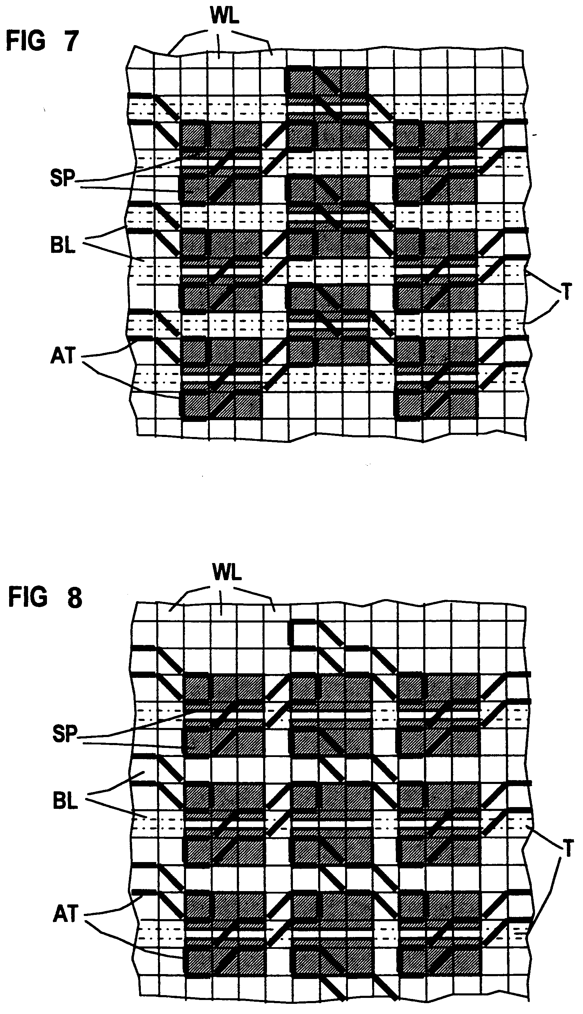

In Figur 7 ist ein Layout für eine dynamische Speicherzellenanordnung mit nach dem erfindungsgemäßen Verfahren hergestellten Speicherkondensatoren dargestellt. In der Speicherzellenanordnung verlaufen senkrecht zueinander Wortleitungen WL und Bitleitungen BL. Die Speicherkondensatoren SP sind als schraffierte Rechtecke eingezeichnet. Die Lage der Auswahltransistorpaare AT ist jeweils als fettgestrichelte Konturlinie eingetragen. Bei der Herstellung werden jeweils zwei Speicherkondensatoren aus einer Schichtstruktur 4' bzw. 24' gebildet. In dem Layout in Figur 13 sind als strichpunktierte Linien T die Trennspalten der Maske eingetragen, mit der die Schichtstrukturen 4' bzw. 24' in die Teilbereiche, die in ihrer Form der Form der Speicherkondensatoren SP entsprechen, aufgetrennt werden. Die Schichtstrukturen 4' bzw. 24' sind in diesem Layout in Spalten angeordnet, wobei benachbarte Spalten um den halben Abstand zwischen den Mittelpunkten benachbarten Schichtstrukturen 4', 24' gegeneinander versetzt angeordnet sind.

Zur Erzielung einer möglichst hohen Packungsdichte ist es vorteilhaft, die Schichtstrukturen mit quadratischem Querschnitt und einer Seitenlänge von 3 F, wobei F die in der jeweiligen Technologie minimale herstellbare Strukturgröße ist, zu bilden. Der Abstand zwischen benachbarten Schichtstrukturen 4', 24' beträgt F. Dann betragen auch die Breiten und Abstände der Wortleitungen WL und Bitleitungen BL jeweils F. Eine Speicherzelle hat in diesem Fall einen Flächenbedarf von 8 F². Um bei einer Strukturgröße F von 0,18 µm, wie sie in der 1GBit-Generation vorgesehen ist, die für die dynamische Speicherzellenanordnung erforderliche Mindestkapazität von 25 fF zu erzielen, sind 12 Schichten aus dotiertem Silizium 4₁ bzw. 24₁ erforderlich. Bei einer Schichtdicke der Schichten aus dotiertem Silizium 4₁ bzw. 24₁ und der germaniumhaltigen Schichten 4₂ bzw. 24₂ von 20 nm ergibt sich dabei eine Stapelhöhe von etwa 0,4 µm.

In Figur 8 ist ein weiteres Layout für eine dynamische Speicherzellenanordnung mit einem nach dem erfindungsgemäßen Verfahren hergestellten Speicherkondensatoren dargestellt. Neben den Wortleitungen WL, Bitleitungen BL, Speicherkondensatoren SP, Auswahltransistorpaaren AT sind wiederum die Trennspalten T dargestellt. Dieses Layout unterscheidet sich von dem in Figur 14 dargestellten Layout dadurch, daß die Schichtstrukturen 4', 24', aus denen durch Auftrennen die Teilbereiche für die Speicherkondensatoren SP gebildet werden, rasterförmig angeordnet sind. Benachbarte Spalten sind dabei nicht gegeneinander versetzt angeordnet. Der Abstand benachbarter Trennspalten T ist in diesem Layout doppelt so groß als in dem in Figur 13 dargestellten Layout. Dafür hat das in Figur 13 dargestellte Layout gegenüber dem in Figur 14 dargestellten Layout den Vorteil, daß an der Auflösungsgrenze eine entspanntere Lithographie vorliegt. Dieses wird mit feineren Strukturen in der Trennmaske erkauft.

Vorzugsweise werden die Trennspalten T in der Trennmaske unter Verwendung eines sogenannten CARL-Lack gebildet. Bei diesen Lacken wird durch eine chemische Nachbehandlung die Breite der Strukturgrößen verändert, so daß die Trennspalte T eine geringere Weite als die minimal herstellbare Strukturgröße F in der jeweiligen Technologie aufweisen.

### Bezugszeichenliste

- 1, 21: Substrat
- 2, 22: isolierende Schicht
- 3, 23: Kontaktlöcher
- 4, 24: Schichtenfolge
- 4', 24': Schichtstruktur
- 4₁, 24₁: Schichten aus dotiertem Silizium
- 4₂, 24₂: germaniumhaltige Schichten
- 5, 25': Stützstruktur
- 25: polykristalline Siliziumschicht
- 6, 26: Kondensatordielektrikum
- 7, 27: Gegenelektrode
- 8, 9: Source/Drain-Gebiete
- 10: Anschlußgebiet
- 11: Bitleitungskontakt
- 12: Bitleitung
- 13: Kanalgebiet
- 14: Wortleitung
- 15: Isolationsstruktur
- WL: Wortleitung
- BL: Bitleitung
- SP: Speicherkondensator
- AT: Auswahltransistorpaar
- T: Trennspalte

## Patentansprüche

1. Verfahren zur Herstellung eines Kondensators für eine Halbleiteranordnung,
- bei dem eine Schichtenfolge (4) erzeugt wird, die jeweils alternierend eine Schicht aus dotiertem Silizium (4₁) und eine germaniumhaltige Schicht (4₂) aufweist,
- bei dem die Schichtenfolge (4) so strukturiert wird, daß mindestens eine Schichtstruktur (4') mit Flanken entsteht,
- bei dem durch selektive Epitaxie von Silizium eine Stützstruktur (5) aus leitfähigem Material gebildet wird, die die Flanken der Schichtstruktur (4') bedeckt,
- bei dem in der Schichtstruktur mindestens eine Öffnung gebildet wird, in der die Oberfläche der Schichten aus dotiertem Silizium (4₁) und der germaniumhaltigen Schichten (4₂) freiliegt,
- bei dem die germaniumhaltigen Schichten (4₂) selektiv zu den Schichten aus dotiertem Silizium (4₁) und der Stützstruktur (5) entfernt werden,
- bei dem die freiliegende Oberfläche der Schichten aus dotiertem Silizium (4₁) und der Stützstruktur (5) mit einem Kondensatordielektrikum (6) versehen werden,
- bei dem an der Oberfläche des Kondensatordielektrikums (6) eine Gateelektrode (7) gebildet wird.

2. Verfahren nach Anspruch 1,
- bei dem die Schichten aus dotiertem Silizium (4₁) durch in situ dotierte Abscheidung von Polysilizium gebildet werden,
- bei dem die germaniumhaltigen Schichten (4₂) durch Abscheidung von Germanium gebildet werden,
- bei dem die Stützstruktur (5) durch selektive Epitaxie von dotiertem Silizium gebildet wird.

3. Verfahren nach Anspruch 1 oder 2,
bei dem die selektive Epitaxie unter Verwendung von SiCl₂H₂, HCl, H₂ und einem Dotiergas durchgeführt wird.

4. Verfahren nach einem der Ansprüche 1 bis 3,
bei dem bei der Bildung der Öffnung in der Schichtstruktur (4') die Schichtstruktur mit der Stützstruktur (5) in zwei Teilbereiche geteilt wird, die durch einen Spalt beabstandet sind.

5. Verfahren nach einem der Ansprüche 1 bis 4,
bei dem die germaniumhaltigen Schichten (4₂, 24₂) einen Germaniumanteil zwischen 10 und 100 Mol% und einen Siliziumanteil zwischen 0 und 90 Mol% aufweisen.

6. Verfahren nach einem der Ansprüche 1 bis 5,
bei dem das Substrat (1) ein Halbleitersubstrat mit Auswahltransistoren (AT), Bitleitungen (BL), Wortleitungen (WL) und einer isolierenden Schicht (2) umfaßt, auf deren Oberfläche die Schichtenfolge (4) aufgebracht wird.
